# EUROPÄISCHE PATENTSCHRIFT

(11) **EP 3 174 204 B1**
(45) Veröffentlichungstag und Bekanntmachung des Hinweises auf die Patenterteilung: **15.06.2022**
(21) Anmeldenummer: 16200834.6
(22) Anmeldetag: 28.11.2016
(51) Int. Cl.: H03K 7/08, H02M 1/08, H03K 17/14

(54) **VERFAHREN UND VORRICHTUNG ZUM STEUERN EINES ELEKTRISCHEN ODER ELEKTRONISCHEN SCHALTELEMENTS**
METHOD AND DEVICE FOR CONTROLLING AN ELECTRIC OR ELECTRONIC SWITCHING ELEMENT
PROCÉDÉ ET DISPOSITIF DE COMMANDE D'UN ÉLÉMENT DE COMMANDE ÉLECTRIQUE OU ÉLECTRONIQUE

(30) Priorität: 27.11.2015 DE 102015120658
(43) Veröffentlichungstag der Anmeldung: 31.05.2017
(73) Patentinhaber: PHOENIX CONTACT GmbH & Co. KG, 32825 Blomberg (DE)
(72) Erfinder: Heuer, Lutz, 32825 Blomberg (DE); Hansmeier, Stephan, 32108 Bad Salzuflen (DE); Schulz, Bernd, 37671 Höxter (DE); Plewka, Dirk, 33039 Nieheim (DE)
(74) Vertreter: Blumbach · Zinngrebe Patentanwälte PartG mbB

(56) Entgegenhaltungen:
- EP-A1- 2 178 211
- WO-A1-2015/051248
- WO-A2-2005/039029
- US-A1- 2006 221 534
- US-A1- 2012 081 173
- US-A1- 2013 114 178
- US-A1- 2014 043 076

## Beschreibung

Die Erfindung betrifft ein Verfahren und eine Vorrichtung zum Steuern eines durch ein elektrisches Signal aktivierbaren elektrischen oder elektronischen Schaltelements, insbesondere zum Schalten einer elektrischen Last, vorzugsweise eines Elektromotors.

Elektrische oder elektronische Schaltelemente zur Schaltung einer elektrischen Last, welche durch elektrische Signale aktivierbar, das heißt schaltbar bzw. betätigbar sind, sind aus dem Stand der Technik bekannt. Bei diesen wird der Schaltzustand nicht durch eine Handbetätigung geändert, sondern durch ein elektrisches Steuer- bzw. Schaltsignal.

Sie sind demnach gegenüber handbetätigten Schaltern abzugrenzen.

Elektrische Schaltelemente können beispielsweise als elektromechanische oder elektromagnetische Schalter wie Relais, Schütze etc. ausgebildet sein.

Elektronische Schaltelemente können beispielsweise als elektronische Schalter oder Halbleiterschalter wie Transistoren, Thyristoren oder Triacs, MOSFET (Metall-Oxid-Halbleiter-Feldeffekttransistor), IGBT-Transistoren (**I**nsulated **G**ate **B**ipolar **T**ransistor) oder IGCT-Thyristoren (**I**ntegrated **G**ate **C**ommutated **T**hyristor) etc. ausgebildet sein.

Das elektrische Schaltsignal zur Aktivierung von elektrischen oder elektronischen Schaltelementen kann je nach Anwendung entweder zeitlich konstant oder auch veränderlich ausgebildet sein.

Aus dem Stand der Technik ist es bekannt, elektrische und elektronische Schaltelemente mittels elektrischer Signale anzusteuern, welche auf einer Pulsweitenmodulation (PWM) basieren, also pulsweitenmoduliert sind. Folglich können elektrische und elektronische Schaltelemente mittels sogenannter PWM-Signale angesteuert werden.

Ferner sind Phasenanschnittsteuerungen zur Steuerung von Elektromotoren bekannt, welche eine Form der Pulsweitenmodulation darstellen können.

Aus der DE 195 22 045 A1 ist eine Schaltungsanordnung für den Leistungsteil eines Pulsweitenmodulators zur Ansteuerung eines elektrischen Motors bekannt, wobei ein Transistor pulsweitenmoduliert angesteuert wird. Dabei wird eine übermäßige Erwärmung eines Kondensators, welcher über den Elektromotor geladen und entladen wird, insbesondere bei kleinen Pulsweiten und niedrigen Drehzahlen des Elektromotors verhindert und der Wirkungsgrad des Elektromotors wesentlich verbessert.

Aus der DE 10 2011 050 719 A1 ist eine Motorantriebsschaltung für Drehstrommotoren bekannt, welche mittels Umrichtereinrichtungen bestromt werden. Diese bestehen aus einem Gleichrichter, der aus einer Wechselstrom-Netzspannung eine Gleichspannung für einen Gleichspannungszwischenkreis herstellt, wobei dieser Zwischenkreis einen Wechselrichter speist. Die Wechselrichter arbeiten auf Basis leistungselektronischer Schalter, die beispielsweise als MOSFET, IGBT-Transistoren oder IGCT-Thyristoren ausgelegt sind. Diese erzeugen durch Pulsweitenmodulation eine veränderliche Spannung, wobei die Höhe der Ausgangspannung sowie die Frequenz in weiten Grenzen geregelt werden können, um sowohl Asynchron- als auch Synchronmotoren zu betreiben.

Ein Verfahren und eine Vorrichtung nach dem Oberbegriff der Ansprüche 1 und 6 sind aus der WO 2005/039029 A2 bekannt.

Zur Erzeugung von PWM-Signalen werden üblicherweise integrierte Schaltungen, Mikrocontroller oder auch diskrete Schaltungen eingesetzt, welche als PWM-Modul ausgebildet sind oder ein solches PWM-Modul aufweisen bzw. umfassen. PWM-Module zur Erzeugung der PWM-Signale werden üblicherweise auch als PWM-Generatoren bezeichnet.

Um elektrische oder elektronische Schaltelemente mittels PWM-Signalen, insbesondere zuverlässig, ansteuern zu können, ist es bekannt, die technischen Charakteristika dieser Schaltelemente bei der Dimensionierung dieser PWM-Signale zugrunde zu legen. Das heißt, dass die PWM-Signale entsprechend so dimensioniert werden bzw. werden müssen, dass eine Aktivierung eines entsprechend anzusteuernden elektrischen oder elektronischen Schaltelements auch für den Fall bzw. die Fälle ungünstigster Betriebs- bzw. Einsatzparameter gewährleistet werden kann.

Beispielsweise sind Schaltschwellen, bei welchen eine ausreichende Spannung und/oder ein ausreichender Strom zur Aktivierung eines elektrischen oder elektronischen Schaltelements vorliegt, insbesondere von Halbleiterschaltern, wie Thyristoren oder Triacs, aber auch von elektromagnetischen Schaltelementen, wie Relais oder Schütze, von der Umgebungstemperatur abhängig.

So ist es beispielsweise zum sicheren Zünden eines Thyristors oder eines Trias erforderlich, insbesondere um auch bei einem steil ansteigenden Hauptstrom ein sicheres Zünden eines Thyristors zu gewährleisen, dass ein elektrischer Steuerimpuls mit einer ausreichender Stromamplitude, beispielsweise mit einem fünffachen Gate-Strom und einer Stromsteilheit von größer als einem Ampere pro Mikrosekunde, vorliegt. Der notwendige Zündimpuls ist dabei abhängig von der Chip-Temperatur des Thyristors.

Infolgedessen ist der benötigte Zündstrom für z.B. Thyristoren und Triacs stark von der der Temperatur der Halbleiter abhängig. Bei geringen Temperaturen wird ein höherer Zündstrom benötigt. Ein höherer Zündstrom führt jedoch bei hohen Temperaturen zu unnötigen Verlusten.

Darüber hinaus kann auch die Spannungsversorgung der elektrischen oder elektronischen Schaltelemente grundsätzlich variabel bzw. nicht immer konstant sein, beispielsweise beim Einsatz von ungeregelten Netzteilen zur Spannungsversorgung.

So werden bei zur Erzeugung der elektrischen Signale zur Ansteuerung der elektrischen oder elektronischen Schaltelemente vorzugsweise integrierte Schaltungen oder Mikrocontroller verwendet. Nachdem Mikrocontroller im Allgemeinen jedoch nicht die notwendige Energie zur Aktivierung der Schaltelemente, insbesondere nicht die notwendige Zündenergie für die Ansteuerimpulse von Thyristoren, zur Verfügung stellen können, müssen oftmals zusätzliche Endverstärkerstufen zur Verstärkung der elektrischen Signale eingesetzt werden.

Endverstärkerstufen können grundsätzlich mit variablen Versorgungsspannungen versorgt werden. Hierfür sind kostengünstige, ungeregelte Netzteile einsetzbar, welche jedoch eine variable Ausgangsspannung aufweisen, beispielsweise zur Geräteversorgung mit 24 Volt und in einen Arbeitsbereich von 18 bis 30 Volt.

Zur Berücksichtigung der oben beschriebenen Problematik schwankender Umgebungstemperaturen und/oder Versorgungsspannungen, ist es daher üblich, PWM-Signale für elektrische und elektronische Schaltelemente entsprechend so zu dimensionieren, dass eine Aktivierung eines entsprechend anzusteuernden elektrischen oder elektronischen Schaltelements auch für den Fall bzw. die Fälle ungünstigster Betriebsparameter gewährleistet werden kann, beispielsweise bei der geringsten anzunehmenden Versorgungsspannung und/oder Umgebungstemperatur.

Diese Vorgehensweise bei der Dimensionierung von PWM-Signalen hat jedoch den Nachteil, dass beim Vorliegen von anderen Betriebsparametern, beispielsweise bei einer sehr hohen Umgebungstemperatur und/oder Versorgungsspannung, sehr hohe Verluste die Folge sind, insbesondere verbunden mit geringen Wirkungsgraden und/oder Schäden an den elektrischen oder elektronischen Schaltelementen bzw. mit weiteren Folgeschäden.

Daher werden vorzugsweise die kleinste zulässige Versorgungsspannung und die geringste Umgebungstemperatur, zum Beispiel 18 Volt und -25° Celsius für die Dimensionierung von elektrischen und elektronischen Schaltelementen genutzt bzw. angenommen und dementsprechend hohe Verluste bei Betriebsparametern von zum Beispiel 30 Volt und +70° Celsius in Kauf genommen.

Vor diesem Hintergrund besteht eine der Erfindung zugrunde liegende Aufgabe vor allem darin, eine Möglichkeit bereitzustellen, um elektrische oder elektronische Schaltelemente, welche durch ein elektrisches Signal aktivierbar sind, auf eine einfache, zuverlässige und/oder sichere Weise zu steuern und dabei nach Möglichkeit auch elektrische Verluste weiter zu reduzieren bzw. die Energieeffizienz und die Wirtschaftlichkeit dieser Schaltelemente zu erhöhen.

Die oben genannten Probleme werden durch die Merkmale der unabhängigen Ansprüche gelöst. Bevorzugte Weiterbildungen sind Gegenstand der abhängigen Ansprüche.

Mittels des PWM-Moduls wird ein PWM-Signal zur Ansteuerung des elektrischen oder elektronischen Schaltelements erzeugt, wobei das PWM-Signal in Abhängigkeit eines Schaltzustands an dem Schaltelement sowie in Abhängigkeit von der Versorgungsspannung und/oder in Abhängigkeit von der Umgebungstemperatur ausgesteuert wird.

Als PWM-Signal im Sinne der Erfindung ist ein elektrisches Signal zu verstehen, welches während einer zeitlichen Periode zwischen wenigstens zwei Werten der Spannung und/oder des Stroms wechselt. Vorzugsweise handelt es sich bei einem PWM-Signal um ein Rechtecksignal, wobei auch andere Signale im Rahmen der Erfindung liegen.

Darüber hinaus kann bei einem als PWM-Signal ausgebildeten elektrischen Signal im Sinne der Erfindung die Frequenz variieren. Zweckmäßig kann die Frequenz auch abhängig von weiteren Parametern oder Messgrößen sein, wie beispielesweise von der mittels der Spannungsmesseinrichtung gemessenen Versorgungsspannung und/oder der mittels der Temperaturmesseinrichtung gemessenen Umgebungstemperatur. Vorzugsweise ist die Frequenz eines PWM-Signals jedoch konstant.

Die Aussteuerung des PWM-Signals im Sinne der Erfindung erfolgt in Abhängigkeit von der Versorgungsspannung und/oder in Abhängigkeit von der Umgebungstemperatur an dem elektrischen oder elektronischen Schaltelement. Unter einer Aussteuerung im Sinne der Erfindung ist die Bildung eines Aussteuergrads, auch als Tastgrad bezeichnet, zu verstehen.

Dieser Aussteuergrad gibt für eine Folge von PWM-Signalen das Verhältnis der Impulsdauer oder Pulsweite eines PWM-Signals im Verhältnis zu einer Periodendauer dieses PWM-Signals an und wird üblicherweise in Prozent angegeben. Durch die Variation des Aussteuergrads lässt sich somit der Gleichwert einer elektrischen Spannung oder eines Stroms ändern. Somit ist durch die Variation des Aussteuergrads ein variables Ansteuern eines Schaltelements auch ohne Verlustleistung möglich.

Es sei ferner darauf hingewiesen, dass unter dem Begriff "Umgebungstemperatur" im Sinne der Patentanmeldung jegliche Temperatur in der Umgebung des entsprechend zu aktivierenden elektrischen oder elektronischen Schaltelements zu verstehen ist, wobei die Temperatur in diesem Zusammenhang auch unmittelbar an einer Oberfläche des Schaltelements oder auch innerhalb des Schaltelements, beispielsweise an einem Halbleiter bzw. an einem Chip erfasst werden kann. So kann die Temperaturmesseinrichtung zweckmäßig auch durch das Schaltelement selbst erfasst oder gemessen und das entsprechende Temperatursignal an einem elektrischen Anschluss des zu aktivierenden Schaltelements abgegriffen werden.

Zusammenfassend wird somit gemäß der Erfindung insbesondere vorgeschlagen, ein PWM-Signal variabel und damit abhängig von einer Versorgungsspannung und/oder Umgebungstemperatur auszubilden.

Vorteile der Erfindung sind es unter anderem, dass Energie und damit auch eine Verlustleistung eingespart wird, wobei auch bei extremen Bedingungen wie der Umgebungstemperatur und/oder der Versorgungsspannung das elektrische oder elektronische Schaltelement sicher geschaltet werden kann. So ist es insbesondere möglich, einen Halbleiter sicher zu schalten und beispielsweise Zündenergie für einen Thyristor oder Triac an einem vorgelagerten Netzteil einzusparen.

Eine bessere Ausnutzung von Zündeinrichtung, insbesondere für Thyristoren und Triacs sowie eine Verbesserung des Wirkungsgrads sind daher möglich. Zudem können auch ungeregelte Netzteile zur Stromversorgung von PWM-Modulen und/oder der Steuereinheit eingesetzt werden und eine gleichbleibende Signalqualität bzw. Konstanz gewährleistet werden.

Weitere Vorteile und Merkmale der Erfindung werden aus der nachfolgenden, beispielhaften Beschreibung bevorzugter Ausführungsformen unter Bezugnahme auf die beigefügte Zeichnung ersichtlich. In der Zeichnung zeigen:
- Fig. 1: eine vereinfacht dargestelltes Blockschaltbild einer Schaltungsanordnung einer Ausführungsform einer Vorrichtung zum Ansteuern von zwei als Triacs ausgebildeten elektronischen Schaltelementen mit einem PWM-Modul,
- Fig. 2: beispielhafte Aussteuergrade von PWM-Signalen in Abhängigkeit von verschiedenen Umgebungstemperaturen bei einer Versorgungsspannung von 18 Volt,
- Fig. 3: beispielhafte Aussteuergrade von PWM-Signalen in Abhängigkeit von verschiedenen Umgebungstemperaturen bei einer Versorgungsspannung von 30 Volt,
- Fig. 4: eine weitere Ausführungsform einer Schaltungsanordnung zur Ansteuerung eines oder mehrerer Schaltelementen, insbesondere Triacs, insbesondere nach Fig. 1.

Es sei darauf hingewiesen, dass in den Figuren gleiche oder gleichwirkende Komponenten mit denselben Bezugszeichen belegt sind.

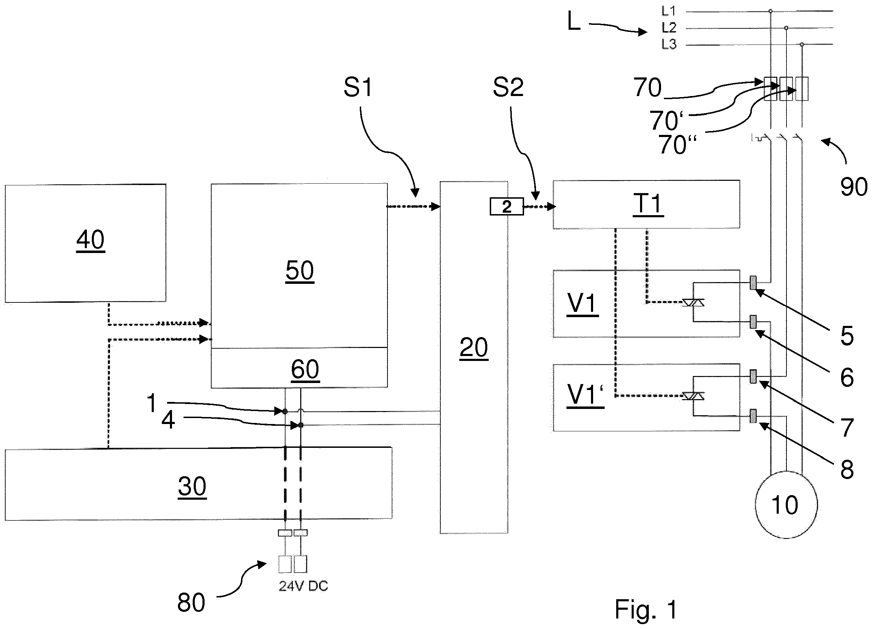

Figur 1 zeigt eine beispielhafte Ausführungsform einer Vorrichtung, in welcher die Erfindung verwirklicht ist, und die zum Ansteuern von elektrischen und elektronischen Schaltelementen V1 und V1' eingesetzt werden kann, welche durch ein elektrisches Signal S2 aktivierbar sind, also geschaltet bzw. betätigt werden können.

Die Vorrichtung gemäß Figur 1 veranschaulicht somit auch eine Durchführung eines erfindungsgemäßen Verfahrens zum Ansteuern von durch elektrische Signale aktivierbaren elektrischen oder elektronischen Schaltelementen.

Die beispielhafte Vorrichtung gemäß Figur 1 ist geeignet zum Steuern der Schaltelemente V1 und V1', das heißt also z.B. zum Ein- als auch zum Ausschalten einer elektrischen Last 10, wobei diese elektrische Last in diesem Fall als Elektromotor ausgebildet ist. Demzufolge verwirklicht die Vorrichtung nach Fig. 1 z.B. einen Motorschalter oder eine Motorsteuerung.
Darüber hinaus können mit der Vorrichtung nach Figur 1 selbstverständlich auch andere und/oder weitere elektrische oder elektronische Schaltelemente gesteuert werden.

Die elektrischen Schaltelemente V1 und V1' sind gemäß dem vorliegenden Beispiel zweckmäßig als Triacs ausgebildet. Alternativ können jedoch auch andere elektrische oder elektronische Schaltelemente zur Anwendung kommen. Beispielsweise können elektromechanische oder elektromagnetische Schalter, insbesondere wie z.B. Relais, und/oder elektronische Schalter oder Halbleiterschalter, insbesondere wie beispielsweise Transistoren, Thyristoren oder Triacs, als Schaltelemente für Motorschalter von Elektromotoren eingesetzt werden.

Zweckmäßig ist der Elektromotor 10 als Drehstrommotor ausgebildet und daher an einem Versorgungsnetz L mit einem ersten, zweiten und dritten Leiter L1, L2 und L3 des Versorgungsnetzes angeschlossen, wobei der erste Leiter L1 in praktischer Ausführung z.B. über den ersten und zweiten Schaltkontakt 5 und 6 des ersten Triacs V1, und der zweite Leiter L2 über den ersten und zweiten Schaltkontakt 7 und 8 des zweiten Triacs V1' mit dem Elektromotor 10 verbunden sind.

Der dritte Leiter L3 ist in diesem Fall z.B. mit dem Elektromotor 10 direkt verbunden, wobei auch dieser dritte Leiter L3 alternativ über ein weiteres elektrisches Schaltelement mit dem Elektromotor verbunden werden könnte.

Ferner sind zwischen dem Versorgungsnetz L und dem Elektromotor 10 zweckmäßig drei Sicherheitsschalter 70, 70', 70", die beispielsweise als elektrische Überlastsicherungen ausgebildet sein können, sowie ein Motorschutzschalter 90 geschaltet.

Zur Ansteuerung der als Triacs ausgebildeten elektrischen Schaltelemente V1 und V1' umfasst die Vorrichtung gemäß Figur 1 ein PWM-Modul 20 zur Erzeugung des PWM-Signals S2, welches zweckmäßig an einem ersten Ausgangskontakt 2 des PWM-Moduls 20 anliegt und ferner zweckmäßig über einen Zündtransformator T1, zur Transformation des PWM-Signals 20, den beiden Schaltelementen V1 und V1' parallel zugeführt wird.

Das PWM-Signal S2 wird von dem PWM-Modul 20 in einem bestimmten Verhältnis und gemäß dem Beispiel nach Figur 1 zweckmäßig in Abhängigkeit von der Versorgungsspannung UB als auch der Umgebungstemperatur TU ausgesteuert, wobei es auch im Rahmen der Erfindung liegt, das PWM-Signal S2 entweder nur in Abhängigkeit von der Versorgungsspannung Ub oder nur in Abhängigkeit von Umgebungstemperatur TU auszusteuern.

Infolgedessen ist zweckmäßig eine die Umgebungstemperatur TU erfassende Temperaturmesseinrichtung 40 an eine Steuereinheit 50 angeschlossen, was in Fig. 1 mittels einer gestrichelten Verbindungslinie mit einem Pfeil angedeutet ist.

Ferner ist zweckmäßig an die Steuereinheit 50 auch eine Spannungsmesseinrichtung 30 angeschlossen, welche die Versorgungsspannung UB der Versorgungsquelle 80 erfasst, was in Fig. 1 ebenfalls mittels gestrichelter Verbindungslinien mit einem Pfeil angedeutet ist. Diese Versorgungsquelle 80 ist vorteilhafter Weise als ungeregeltes Netzteil ausgebildet.

Die Temperaturmesseinrichtung 40 und die Spannungsmesseinrichtung 30 können zweckmäßig als eine Spannungsteiler-Schaltungsanordnung ausgebildet sein.

Die Steuerung 50, welche zweckmäßig einen Microcontroller umfasst, ist optional separat zu dem PWM-Modul 20 angeordnet. Alternativ kann die Steuerung 50 jedoch z.B. auch von dem PWM-Modul umfasst sein.

Die Steuerung 50 weist ferner zweckmäßig auch ein geregeltes Netzteil 60 auf. Das Netzteil 60 sowie das PWM-Modul 20 wird dabei vorteilhaft von der einzigen Versorgungsquelle 80, das heißt insbesondere dem ungeregelten Netzteil, beispielsweise mit einer 24-Volt-Gleichspannung versorgt, wobei hierzu sowohl das PWM-Modul 20 als auch die Steuereinheit 50 an dem ersten und zweiten Kontakt der Versorgungsquelle 80 angeschlossen sind.

Dementsprechend werden in einem optionalen Zwischenschritt in der Steuereinheit 50 aus der Umgebungstemperatur TU und der Versorgungsspannung UB ein elektrisches Steuersignal S1 gebildet, welches gemäß dem gestrichelten Pfeil in Figur 1 zweckmäßig direkt dem PWM-Modul 20 zur Aussteuerung des PWM-Signals S2 zugeführt wird.

Infolgedessen wird mittels des PWM-Moduls 20 das PWM-Signal S2 in Abhängigkeit von der Versorgungsspannung UB und in Abhängigkeit von der Umgebungstemperatur TU ausgesteuert und hiermit die Schaltelemente V1 und V1' angesteuert.

In alternativen Ausgestaltungen der Erfindung, welche aus Gründen der Übersichtlichkeit jedoch in den Figuren nicht gezeigt ist, umfasst entweder das PWM-Modul 20 die Steuereinheit 50 oder die Steuereinheit 50 umfasst das PWM-Modul 20.

Ferner kann das PWM-Modul 20 zweckmäßig auch eine zusätzliche Endverstärkerstufe zur Verstärkung des PWM-Signals S2 aufweisen, welche in den Figuren gleichermaßen aus Gründen der Übersichtlichkeit jedoch nicht gezeigt ist.

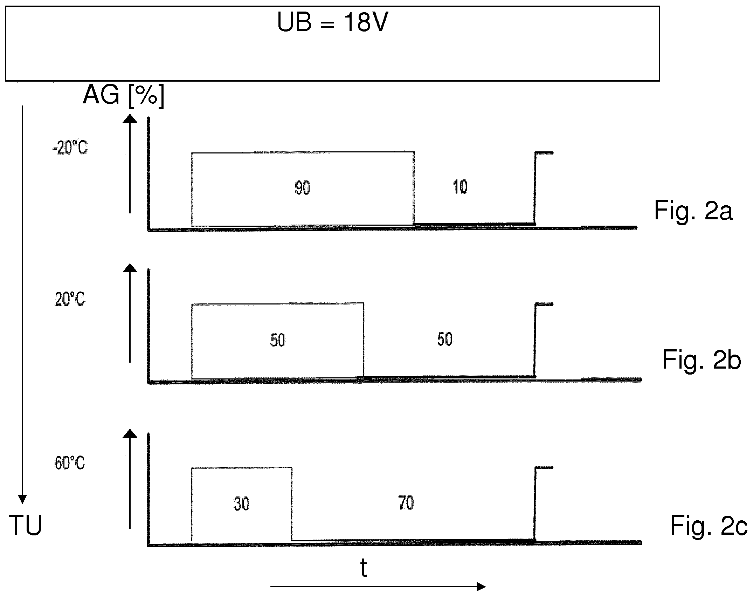

Die Figuren 2a bis 3c zeigen beispielhaft verschiedene PWM-Signale 20 zur Steuerung von elektrischen oder elektronischen Schaltelementen V1 und V1' in Abhängigkeit von der Umgebungstemperatur TU und der Versorgungsspannung UB, welche z.B. an der Temperaturmesseinrichtung 40 und einer Spannungsmesseinrichtung 30 gemäß Fig. 1 gemessen werden.

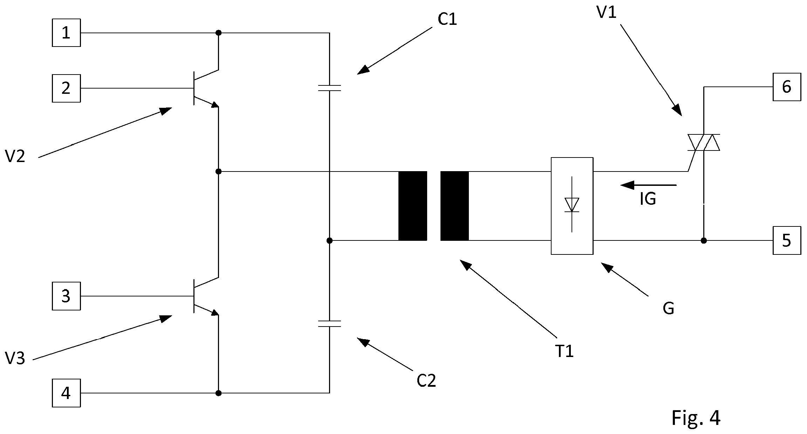

Diese PWM-Signale 20 können somit beispielsweise in einem PWM-Modul gemäß Figur 1 gebildet werden und in einer Vorrichtung gemäß Figur 1 oder 4 oder auch in einer alternativen Schaltungsanordnung zum Einsatz kommen.

Die PWM-Signale 20 sind zweckmäßig als Rechtecksignale ausgebildet, wobei auch andere Signalarten bzw. -typen im Rahmen der Erfindung liegen.

Die Figuren 2a bis 2c zeigen beispielhaft bei einer konstanten Versorgungsspannung von 18 Volt und verschiedenen, durch die Temperaturmesseinrichtung 40 gemessenen Umgebungstemperaturen TU entsprechende Aussteuergrade AG, das heißt verschiedene Verhältnisse von Impulsweiten zu einer jeweiligen Periodendauer eines PWM-Signals. Die Frequenz des PWM-Signals 20 sei hierbei konstant.

So beträgt beispielsweise gemäß Fig. 2a bei einer Umgebungstemperatur TU von -20° Celsius der Aussteuergrad AG des PWM-Signals 20 90 Prozent. Das heißt ein elektrisches Schaltelement V1 ist zu 90 Prozent der Periodendauer eingeschaltet und zu 10 Prozent der Periodendauer ausgeschaltet.

Bei einer Erhöhung auf 20° Celsius ist gemäß Figur 2b der Aussteuergrad AG beispielsweise auf 50 Prozent verringert.

Wenn die Umgebungstemperatur weiter auf 60° Celsius erhöht wird, so beträgt gemäß Fig. 2c der Aussteuergrad AG lediglich 30 Prozent.

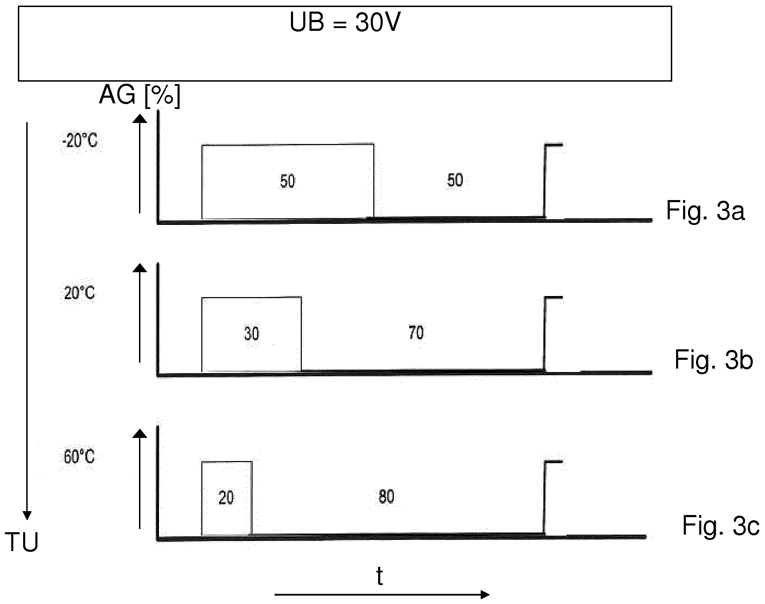

Die Figuren 3a bis 3c zeigen ferner im Unterschied zu den Figuren 2a bis 2c PWM-Signale 20 bei einer Versorgungsspannung UB von 30 Volt in Abhängigkeit von verschiedenen Umgebungstemperaturen TU. Die Frequenz des PWM-Signals 20 sei hierbei ebenfalls konstant und insbesondere aus Vergleichsgründen identisch mit der Frequenz der PWM-Signale 20 gemäß den Figuren 2a bis 2c.

Der Aussteuergrad AG des PWM-Signals 20 beträgt gemäß Fig. 3a nunmehr im Unterschied zu Fig. 2a bei einer Umgebungstemperatur TU von -20° Celsius lediglich 50 Prozent. Wird die Umgebungstemperatur TU auf 20° erhöht, so verringert sich der Aussteuergrad AG gemäß Fig. 3b auf 30 Prozent. Wird die Umgebungstemperatur TU weiter auf 60° erhöht, so verringert sich gemäß Fig. 3c der Aussteuergrad AG auf 20 Prozent.

Wie den Figuren 2a bis 3c somit beispielhaft zu entnehmen ist, kann der Aussteuergrad AG zweckmäßig in Abhängigkeit von der Versorgungsspannung UB und/oder der Umgebungstemperatur TU derart gesteuert werden, dass bei einer Erhöhung der Versorgungsspannung UB der Aussteuergrad AG verringert wird und bei einer Verringerung der Versorgungsspannung UB vergrößert wird.

Darüber hinaus wird bei einer Erhöhung der Umgebungstemperatur TU der Aussteuergrad AG zweckmäßig verringert und bei einer Verringerung der Umgebungstemperatur TU vergrößert.

Zweckmäßig ist der Aussteuergrad AG derart von der Versorgungsspannung UB und/oder von der Umgebungstemperatur TU abhängig, dass der Aussteuergrad AG eines PWM-Signals der Versorgungsspannung UB und/oder von der Umgebungstemperatur TU einem linearen Zusammenhang, einem vorbestimmten Algorithmus und/oder in einem diskreten Zusammenhang, das heißt mit diskreten Werten, folgt. Vorzugsweise wird der Aussteuergrad AG aus einer Tabelle mit vorbestimmten Werten des Aussteuergrads AG, die vorbestimmten Werten der Versorgungsspannung UB und/oder der Umgebungstemperatur TU zugeordnet sind, ausgewählt.

Zweckmäßig können diese Werte in dem PWM-Modul 20, in einem Mikrocontroller und/oder der Steuereinheit 50 gespeichert sein. Alternativ, können anstelle einer Tabelle auch eine oder mehrere diskrete Schaltungen bzw. Schaltungsanordnungen zur Anwendung kommen.

Figur 4 zeigt eine besonders vorteilhafte Ausgestaltung einer Schaltungsanordnung zur Ansteuerung eines oder mehrerer Schaltelemente, insbesondere nach Fig. 1, z.B. des elektrischen Schaltelements V1 gemäß Figur 1, welches zweckmäßig als Triac ausgebildet ist. Das zweite Schaltelement V1' gemäß Figur 1 ist in Figur 4 jedoch nicht gezeigt. Dieses kann zweckmäßig zusätzlich an die Sekundärwicklung des Zündtransformators T1 in paralleler Weise, über eine parallele zweite Sekundärwicklung eines entsprechend abgewandelten Zündtransformators oder in einer weiteren Schaltungsanordnung wie gemäß Figur 4 angeschlossen sein.

Die Schaltungsanordnung gemäß Figur 4 ist ferner als sogenannte Gegentaktstufe ausgebildet und verbessert den Wirkungsgrad des Zündtransformators T1, insbesondere durch die Ausnutzung von dessen Kernmaterial während beider Wechselstrom-Halbwellen, insbesondere für den vorliegenden Fall der Aktivierung eines als Triac ausgebildeten ersten Schaltelements V1 zum Schalten einer elektrischen Wechsel- oder Drehstrom-Last, das heißt eines Wechsel- oder Drehstrom-Motors.

Die beiden Kontakte 1 und 4 der Schaltungsanordnung gemäß Figur 4 sind jeweils an eine Versorgungsquelle, z.B. die Versorgungsquelle 80 angeschlossen und entsprechen in diesem Fall den ersten und zweiten Kontakten 1 und 4 der Versorgungsquelle gemäß Figur 1.

Ferner entspricht der Kontakt 2 der Schaltungsanordnung gemäß Figur 4 dem ersten Ausgangskontakt 2 des PWM-Moduls 20 und ist demgemäß an den Ausgang des PWM-Moduls 20 angeschlossen.

Darüber hinaus ein Kontakt 3 zur Bildung der Gegentaktstufe der Schaltungsanordnung gemäß Figur 4 als ein weiterer, zweiter Ausgangskontakt 3 des PWM-Moduls vorgesehen und ist demgemäß in Abwandlung zu Figur 1 ebenfalls an einen Ausgang des PWM-Moduls 20 angeschlossen bzw. ist der Kontakt 3 in Fig. 1 aus Gründen der einfacheren Darstellung nicht gezeigt.

Ferner entsprechen die Kontakte 5 und 6 dem ersten und zweiten Schaltkontakt 5 und 6 des ersten Schaltelements V1 gemäß Figur 1, welche demnach beispielsweise an den ersten Leiter L1 des Versorgungsnetzes angeschlossen sein können.

Im Betrieb der erfindungemäßen Vorrichtung gemäß der Figur 4 insbesondere auch in Verbindung mit Figur 1, werden die Ausgangskontakte 2 und 3 der Schaltungsanordnung gemäß Figur 4 jeweils abwechselnd mit zueinander inversen PWM-Signalen angesteuert, welche z.B. mittels des PWM-Moduls 20 erzeugt werden und an dessen Ausgangskontakten 2 und 3 anliegen.

Dementsprechend werden der erste und der zweite in Figur 4 gezeigte Transistor V2 und V3 mittels dieser zueinander inversen PWM-Signale angesteuert. Demgemäß findet abwechselnd eine Entladung jeweils über den ersten oder den zweiten Kondensator C1 und C2, welche als Halbbrücken zur Energiespeicherung ausgebildet sind, statt, und die Primärspule des Zündtransformators T1 wird daher abwechselnd in jeweils unterschiedlichen Richtungen durchflossen. Demzufolge fließt der in der Sekundärspule des Zündtransformators T1 transformierte Strom ebenfalls abwechselnd in umgekehrte Richtungen. Vorzugsweise wird durch eine Gleichrichtung G der Zündstrom IG für die Zündung des Triacs erzeugt.

Das PWM-Signal wird somit von dem PWM-Modul an den Transistoren V2 und V3, zweckmäßig in einem bestimmten Verhältnis, insbesondere jedoch abhängig von der Versorgungsspannung UB und der Umgebungstemperatur TU dem Triac V1 als Zündstrom IG zur Verfügung gestellt. Durch diese Variation des PWM-Signals ist somit sicher gestellt, dass sich der notwendige Zündstrom an dem Triac V1 einstellt.

Die Erfindung ermöglicht somit ein besonders effizientes Steuern von elektrischen und elektronischen Schaltelementen, welche durch ein elektrisches Signal, aktivierbar, das heißt schaltbar bzw. betätigbar sind. Beispielsweise ist mit der Erfindung auch eine besonders vorteilhafte Ausführung eines Schaltgeräts zum sicheren Ein- und Ausschalten einer elektrischen Last, insbesondere eines elektrischen Motors, sowie zur energiesparenden Steuerung und/oder Regelung von Vorrichtungen zur Überwachung oder zur Überprüfung von elektrischen Speichern, wie Kondensatoren, Batterien, Akkumulatoren, etc. möglich, bei welchen elektrische oder elektronische Schaltelemente, welche durch ein elektrisches Signal, aktivierbar, das heißt schaltbar bzw. betätigbar sind, eingesetzt werden.

Eine besonders vorteilhafte Anwendung der Erfindung ist insbesondere bei sogenannten Hybrid-Ausgangsstufen oder Hybrid-Schaltern, bestehend aus Halbleiterschaltern wie Triacs oder Thyristoren und Relais, möglich.

Bei derartigen Hybrid-Schaltern wird beispielsweise nach dem Einschalten der Halbleiterschalter ein Stromfluss von einem Bypass-Relais übernommen, wobei der Halbleiterschalter anschließend keinen Strom mehr führt. In einem darauf folgenden, eingeschalteten Zustand sind dann die Relaisspulen des Relais ständig angesteuert, wobei in dieser Halte-Phase nur noch ein geringerer Magnetisierungsstrom in dem Relais benötigt wird.

Um hierbei mittels der Erfindung eine bessere Energieeffizienz zu gewährleisten, kann eine Pulsweitenmodulation für die Ansteuerung der Relaisspulen realisiert werden.

Der Aussteuergrad eines PWM-Signals wird in diesem Fall dann zweckmäßig dynamisch in Abhängigkeit von Schaltsituationen oder Schaltzuständen, sowie in Abhängigkeit einer zur Verfügung stehenden Versorgungsspannung, sowie gegebenenfalls in Abhängigkeit der Umgebungstemperatur gebildet werden. Mögliche Schaltzustände können zweckmäßig ein erster Schaltzustand, bei der ein Relais anzieht, und ein zweiter Schaltzustand sein, bei der ein das Relais dauerhaft angesteuert ist bzw. angezogen ist.

Ein oder mehrere Schaltzustände an einem Schaltelement sind mittels einer geeigneten Messeinrichtung, welche direkt oder indirekt mit dem Schaltelement verbunden ist, erfassbar

Zur energiesparenden Steuerung und/oder Regelung von Vorrichtungen zur Überwachung oder zur Überprüfung von elektrischen Speichern kann mittels der Erfindung zweckmäßig der Aussteuergrad eines PWM-Signals nachgeführt werden.

So ist es insbesondere zweckmäßig, wenn eine Versorgungsspannung an der als Speicher ausgebildeten Versorgungsquelle abgeschaltet wird und die Spannung an dem Speicher absinkt, den Aussteuergrad des PWM-Signals nachzuführen, um einen erforderlichen Magnetisierungsstrom in den Relais möglichst lange aufrecht erhalten zu können. Auf diese Welse kann die zur Verfügung stehende gespeicherte Energie in dem Speicher bzw. der Versorgungsquelle maximal ausgenutzt werden und der Energiespeicher möglichst klein dimensioniert werden. Beispielsweise kann, wenn eine Versorgungsspannung auf 15V fällt, der Aussteuergrad des PWM-Signals ca. 50 Prozent betragen. Steigt die Versorgungsspannung auf z.B. 30 Volt, so kann der Aussteuergrad des PWM-Signals auf ca. 25 Prozent abgesenkt werden.

Durch diese Nachführung eines PWM-Signals ist es somit möglich, eine Versorgungsquelle wie ein Netzteil, einen Akkumulator, eine Batterie, einen Kondensator etc, auf zum Beispiel ca. ein Viertel des sonst üblichen Wertes zu dimensionieren.

Ein weiterer Nutzen ist die Energieeinsparung, welche außerdem eine kleinere und damit günstigere Dimensionierung der Bauteile im geräteinternen Netzteil zulässt.
Durch einen nachgeführten Aussteuergrad des PWM-Signals wird somit immer nur so viel Energie aufgenommen, wie zum Betrieb eines elektronischen oder elektrischen Schaltelements, wie ein Relais etc., in der jeweiligen Schaltsituation tatsächlich erforderlich ist.

### Bezugszeichen

- 1: erster Kontakt der Versorgungsquelle
- 2: erster Ausgangskontakt des PWM-Moduls
- 3: zweiter Ausgangskontakt des PWM-Moduls
- 4: zweiter Kontakt der Versorgungsquelle
- 5: erster Schaltkontakt des ersten Schaltelements
- 6: zweiter Schaltkontakt des ersten Schaltelements
- 7: erster Schaltkontakt des zweiten Schaltelements
- 8: zweiter Schaltkontakt des zweiten Schaltelements
- 10: Elektrische Last / Elektromotor
- 20: PWM-Modul
- 30: Spannungsmesseinrichtung
- 40: Temperaturmesseinrichtung
- 50: Steuereinheit
- 60: geregeltes Netzteil
- 70,: 70', 70" Sicherheitsschalter
- 80: Versorgungsquelle / ungeregeltes Netzteil
- 90: Motorschutzschalter
- AG: Aussteuergrad
- C1: erster Kondensator
- C1: zweiter Kondensator
- IG: Zündstrom
- L: Versorgungsnetz
- L1, L2, L3: erster, zweiter, dritter Leiter des Versorgungsnetzes
- S2: PWM-Signal
- S1: Steuersignal
- t: Zeit
- T1: Zündtransformator
- G: Gleichrichter
- UB: Versorgungsspannung
- TU: Umgebungstemperatur
- V1: erstes Schaltelement / Triac
- V1': zweites Schaltelement / Triac
- V2: erster Transistor
- V3: zweiter Transistor

## Patentansprüche

1. Verfahren zum Steuern eines durch ein elektrisches Signal aktivierbaren elektrischen oder elektronischen Schaltelements (1), das Verfahren die Schritte umfassend:
- Anlegen einer Versorgungsspannung an ein PWM-Modul (2),
- Messen der Versorgungsspannung (Ub) mit einer Spannungsmesseinrichtung (30) und/oder einer Umgebungstemperatur (TU) an dem Schaltelement (V1, V1') mit einer Temperaturmesseinrichtung (40),
- Erzeugen mit dem PWM-Modul (20) eines PWM-Signals (S2) zur Ansteuerung des Schaltelements (V1, V1'), **dadurch gekennzeichnet, dass** ein Hybrid-Schalter als Schaltelement (V1,V1') eingesetzt wird, wobei der Hybrid-Schalter aus einem Halbleiterschalter und einem Relais besteht und das PWM-Signal (S2) in Abhängigkeit eines Schaltzustands an dem Schaltelement (V1, V1') sowie in Abhängigkeit von der Versorgungsspannung (UB) und/oder in Abhängigkeit von der Umgebungstemperatur (TU) ausgesteuert wird.

2. Verfahren nach Anspruch 1, wobei das PWM-Signal (S2) in Abhängigkeit von der Versorgungsspannung und/oder in Abhängigkeit von der Umgebungstemperatur linear, einem vorbestimmten Algorithmus und/oder diskreten Werten folgend ausgesteuert wird.

3. Verfahren nach Anspruch 1 oder 2, wobei der Aussteuergrad aus einer Tabelle mit vorbestimmten Werten des Aussteuergrads, welche vorbestimmten Werten der Versorgungsspannung und/oder der Umgebungstemperatur zugeordnet sind, ausgewählt wird.

4. Verfahren nach einem der Ansprüche 1 bis 3, wobei das PWM-Signal derart in Abhängigkeit von der Versorgungsspannung und/oder der Umgebungstemperatur ausgesteuert wird, dass bei einer Erhöhung der Versorgungsspannung der Aussteuergrad verringert wird und bei einer Verringerung der Versorgungsspannung der Aussteuergrad vergrößert wird und/oder bei einer Erhöhung der Umgehungstemperatur der Aussteuergrad verringert wird und bei einer Verringerung der Umgehungstemperatur der Aussteuergrad vergrößert wird.

5. Verfahren nach einem der Ansprüche 1 bis 4, wobei das PWM-Signal (S2) über einen Transformator (T1) dem Schaltelement (V1, V1') zugeführt wird.

6. Vorrichtung zum Ansteuern eines durch ein elektrisches Signal aktivierbaren elektrischen oder elektronischen Schaltelements (V1, V1'), insbesondere zur Durchführung eines Verfahrens nach einem der Ansprüche 1 bis 5, die Vorrichtung umfassend:
- ein PWM-Modul (20) zur Erzeugung eines PWM-Signals (S2) zur Ansteuerung des Schaltelements (V1, V1'), wobei an dem PWM-Modul (2) eine Versorgungsspannung anlegbar ist und
- eine Spannungsmesseinrichtung (30) zur Messung der Versorgungsspannung an dem PWM-Modul (20) und/oder
- eine Temperaturmesseinrichtung (40) zur Messung einer Umgebungstemperatur an dem Schaltelement (V1, V1'),
**dadurch gekennzeichnet, dass**
das Schaltelement (V1, V1') als Hybrid-Schalter ausgebildet ist, wobei der Hybrid-Schalter aus einem Halbleiterschalter und einem Relais besteht und die Vorrichtung ausgebildet ist zum Aussteuern des PWM-Signals (S2) in Abhängigkeit eines Schaltzustands an dem Schaltelement (V1, V1') sowie in Abhängigkeit von der Versorgungsspannung und/oder in Abhängigkeit von der Umgebungstemperatur, wobei hierzu ferner eine Messeinrichtung zur Erfassung des Schaltzustands mitumfasst ist.

7. Vorrichtung nach Anspruch 6, ferner umfassend eine Steuereinheit (50) zur Erzeugung eines Steuersignals (S1), welches von der Versorgungsspannung (UB) und/oder der Umgebungstemperatur (TU) abhängig ist, wobei das Steuersignal (S1) dem PWM-Modul (20) zuführbar ist.

8. Vorrichtung nach Anspruch 6 oder 7, ferner umfassend eine Endverstärkerstufe zur Verstärkung des PWM-Signals (S1) und/oder ein ungeregeltes Netzteil (80) zur Erzeugung der Versorgungsspannung (UB) und zur Versorgung des PWM-Moduls (20) und/oder der Steuereinheit (50).

9. Vorrichtung nach Anspruch 8, wobei das PWM-Modul (20) die Endverstärkerstufe umfasst.

10. Vorrichtung nach einem der Ansprüche 7 bis 9, wobei die Steuereinheit (50) von einem geregelten Netzteil (60) versorgbar ist.

## Claims

1. A method of controlling an electrical or electronic switching element (1) that can be activated by an electrical signal, the method comprising the steps of:
- applying a supply voltage to a PWM module (2),
- measuring the supply voltage (Ub) with a voltage measuring device (30) and/or an ambient temperature (TU) on the switching element (V1, V1') with a temperature measuring device (40),
- generating with the PWM module (20) a PWM signal (S2) for actuating the switching element (V1, V1'),
**characterized in that**
a Hybrid switch is used as switching element (V1, V1'), the hybrid switch consisting of a semiconductor switch and a relay, and the PWM signal (S2) being controlled as a function of a switching state at the switching element (V1, V1') and as a function of the supply voltage (UB) and/or as a function of the ambient temperature (TU).

2. Method according to claim 1, wherein the PWM signal (S2) is controlled linearly, following a predetermined algorithm and/or discretely as a function of the supply voltage and/or as a function of the ambient temperature.

3. Method according to claim 1 or 2, wherein the modulation level is selected from a table of predetermined values of modulation level associated with predetermined values of supply voltage and/or ambient temperature.

4. Method according to any one of claims 1 to 3, wherein the PWM signal is controlled as a function of the supply voltage and/or the ambient temperature in such a way that the modulation level is reduced when the supply voltage is increased and the modulation level is increased when the supply voltage is reduced and/or that the modulation level is reduced when the ambient temperature is increased and the modulation level is increased when the ambient temperature is reduced.

5. Method according to any one of claims 1 to 4, wherein the PWM signal (S2) is supplied to the switching element (V1, V1') via a transformer (T1).

6. Device for controlling an electrical or electronic switching element (V1, V1') which can be activated by an electrical signal, in particular for carrying out a method according to one of claims 1 to 5, the device comprising:
- a PWM module (20) for generating a PWM signal (S2) for driving the switching element (V1, V1'), wherein a supply voltage is applied to the PWM module (2) of a switching element (V1, V1').
- a voltage measuring device (30) for measuring the supply voltage at the PWM module (20) and/or
- a temperature measuring device (40) for measuring an ambient temperature at the switching element (V1, V1'),
**characterized in that**
the switching element (V1, V1') is designed as a hybrid switch, the hybrid switch consisting of a semiconductor switch and a relay, and the device being designed to control the PWM signal (S2) as a function of a switching state at the switching element (V1, V1') and as a function of the supply voltage and/or as a function of the ambient temperature, wherein a measuring device for detecting the switching state also being included for this purpose.

7. Device according to claim 6, further comprising a control unit (50) for generating a control signal (S1) which is dependent on the supply voltage (UB) and/or the ambient temperature (TU), wherein the control signal (S1) can be supplied to the PWM module (20).

8. Device according to claim 6 or 7, further comprising a output amplifier stage for amplifying the PWM signal (S1) and/or an unregulated power supply (80) for generating the supply voltage (UB) and for powering the PWM module (20) and/or the control unit (50).

9. Device according to claim 8, wherein the PWM module (20) comprises the output amplifier stage.

10. Device according to any one of claims 7 to 9, wherein the control unit (50) can be supplied by a regulated power supply (60).

## Revendications

1. Procédé de commande d'un élément de commutation (1) électrique ou électronique pouvant être activé par un signal électrique, le procédé comprenant les étapes consistant à :
- appliquer une tension d'alimentation à un module MLI (2),
- mesurer la tension d'alimentation (Ub) avec un équipement de mesure de tension (30) et/ou une température ambiante (TU) au niveau de l'élément de commutation (V1, V1') avec un équipement de mesure de température (40),
- produire, avec le module MLI (20), un signal MLI (S2) pour piloter l'élément de commutation (V1, V1'),
**caractérisé en ce que**
un commutateur hybride est utilisé en tant qu'élément de commutation (V1, V1'), où le commutateur hybride est composé d'un commutateur à semi-conducteur et d'un relais et le signal MLI (S2) est réglé en fonction d'un état de commutation au niveau de l'élément de commutation (V1, V1') ainsi qu'en fonction de la tension d'alimentation (UB) et/ou en fonction de la température ambiante (TU).

2. Procédé selon la revendication 1, dans lequel le signal MLI (S2) est réglé en fonction de la tension d'alimentation et/ou en fonction de la température ambiante de façon linéaire, en suivant un algorithme prédéterminé et/ou des valeurs discrètes.

3. Procédé selon la revendication 1 ou 2, dans lequel le rapport cyclique est sélectionné à partir d'une table avec des valeurs prédéterminées du rapport cyclique, lesquelles valeurs prédéterminées sont attribuées à la tension d'alimentation et/ou à la température ambiante.

4. Procédé selon l'une des revendications 1 à 3, dans lequel le signal MLI est réglé en fonction de la tension d'alimentation et/ou de la température ambiante de telle sorte que lors d'une augmentation de la tension d'alimentation le rapport cyclique est réduit et lors d'une réduction de la tension d'alimentation le rapport cyclique est accru et/ou lors d'une augmentation de la température ambiante le rapport cyclique est réduit et lors d'une réduction de la température ambiante le rapport cyclique est accru.

5. Procédé selon l'une des revendications 1 à 4, dans lequel le signal MLI (S2) est amené à l'élément de commutation (V1, V1') via un transformateur (T1) .

6. Dispositif d'attaque d'un élément de commutation (V1, V1') électrique ou électronique pouvant être activé par un signal électrique, en particulier pour exécuter un procédé selon l'une des revendications 1 à 5, le dispositif comprenant :
- un module MLI (20) pour produire un signal MLI (S2) afin d'attaquer l'élément de commutation (V1, V1'), où une tension d'alimentation peut être appliquée au module MLI (2) et
- un équipement de mesure de tension (30) pour mesurer la tension d'alimentation au niveau du module MLI (20) et/ou
- un équipement de mesure de température (40) pour mesurer une température ambiante au niveau de l'élément de commutation (V1, V1'),
**caractérisé en ce que**
l'élément de commutation (V1, V1') est conçu en tant que commutateur hybride, où le commutateur hybride est composé d'un commutateur à semi-conducteur et d'un relais et le dispositif est conçu pour régler le signal MLI (S2) en fonction d'un état de commutation au niveau de l'élément de commutation (V1, V1') ainsi qu'en fonction de la tension d'alimentation et/ou en fonction de la température ambiante, où, à cet effet, un équipement de mesure est en outre inclus pour saisir l'état de commutation.

7. Dispositif selon la revendication 6, comprenant en outre une unité de commande (50) pour produire un signal de commande (S1), lequel dépend de la tension d'alimentation (UB) et/ou de la température ambiante (TU), dans lequel le signal de commande (S1) peut être amené au module MLI (20).

8. Dispositif selon la revendication 6 ou 7, comprenant en outre un étage d'amplificateur final pour amplifier le signal MLI (S1) et/ou une partie de réseau non réglée (80) pour produire la tension d'alimentation (UB) et pour alimenter le module MLI (20) et/ou l'unité de commande (50) .

9. Dispositif selon la revendication 8, dans lequel le module MLI (20) comprend l'étage d'amplificateur final.

10. Dispositif selon l'une des revendications 7 à 9, dans lequel l'unité de commande (50) peut être alimentée par une partie de réseau réglée (60).
